**Europäisches Patentamt**

**European Patent Office**

**Office européen des brevets**

(19)

(11) Veröffentlichungsnummer : **0 031 061 B1**

(12) **EUROPÄISCHE PATENTSCHRIFT**

(45) Veröffentlichungstag der Patentschrift :
**11.04.84**

(21) Anmeldenummer : **80107685.2**

(22) Anmeldetag : **06.12.80**

(51) Int. Cl.³ : **H 03 H 1/00**, H 01 F 15/02, H 04 B 3/56

(54) **Sperrfilter für Geräte mit trägerfrequenter Ausnutzung von Niederspannungsleitungen.**

(30) Priorität : **22.12.79 DE 2952036**
**25.01.80 DE 3002637**

(43) Veröffentlichungstag der Anmeldung :
**01.07.81 Patentblatt 81/26**

(45) Bekanntmachung des Hinweises auf die Patenterteilung : **11.04.84 Patentblatt 84/15**

(84) Benannte Vertragsstaaten :
**AT BE CH FR GB IT LI NL SE**

(56) Entgegenhaltungen :
**GB-A- 287 847**
**US-A- 2 052 338**
**NACHRICHTEN ELEKTRONIK, Band 32, Nr. 1, Januar
1978, Seiten 11-12, Heidelberg, DE. F. MUNTER et al.:
"Ein neuartiges Hochfrequenzsperrfilter für die
Nachrichtenübertragung auf Dreiphasen-Hausinstallationsnetzen"**
**BAUTEILE REPORT, Band 13, Nr. 4, September 1975,
Seiten 108-111, Berlin-München, DE. V. KÜBEL:
"Eigenschaften und Anwendung von Funk-Enstörfiltern mit stromkompensierten Drosseln"**

(73) Patentinhaber : **BROWN, BOVERI & CIE Aktiengesellschaft Mannheim
Kallstadter Strasse 1
D-6800 Mannheim Käfertal (DE)**

(72) Erfinder : **Zapp, Robert
Löher Weg 35
D-5885 Schalksmühle (DE)**
Erfinder : **Wichmann, Ewald
Blücherweg 31
D-5880 Lüdenscheid (DE)**

(74) Vertreter : **Kempe, Wolfgang, Dr. et al
c/o Brown, Boveri & Cie AG Postfach 351
D-6800 Mannheim 1 (DE)**

## Sperrfilter für Geräte mit trägerfrequenter Ausnutzung von Niederspannungsleitungen

Die Erfindung betrifft einen Sperrfilter der im Oberbegriff des Anspruchs 1 genannten Art.

Bei Nachrichtenübermittlungs-Anlagen, die zur Signalübermittlung die Niederspannungsleitungen des Haus-Installationsnetzes ausnutzen, z. B. Wechselsprechanlagen, Signal- oder Warnanlagen, besteht das Problem, daß die über die Niederspannungsleitungen übertragene hochfrequenz Sendespannung nicht über das interne Installationsnetz eines Hauses oder einer Wohnung hinaus ausgebreitet werden darf. Obwohl bereits durch die Leitungsimpedanzen des Installationsnetzes und die Längsinduktivitäten des vorgeschalteten Zählers eine gewisse Dämpfung der Sendespannung erreicht wird, besteht je nach Beschaffenheit des Installationsnetzes und der an diesem Netz angeschlossenen Verbraucher nicht die absolute Sicherheit, daß die Sendespannung das interne Installationsnetz nicht überschreitet. In diesen Fällen ist es erforderlich, ein zusätzliches Dämpfungsglied zur Abblockung der hochfrequenten Sendespannung vorzusehen. So sind z. B. Sperrfilter in der eingangs beschriebenen Art von der Fa. VALVO bekannt. Diese sind jedoch für den vorliegenden Anwendungsfall nicht geeignet, da sie wegen ihrer vielen Spulen-Windungen nur für relativ geringe Ströme anwendbar sind.

Bei der Ausnutzung der Niederspannungsleitungen für Nachrichtenübermittlungs-Anlagen oder dergl. ist zu berücksichtigen, daß ein als Bandsperre zu verwendender Sperrfilter so ausgebildet sein muß, daß er die innerhalb der Hausinstallation auftretenden Lastströme schadenfrei passieren läßt. Die zu beherrschenden Netzströme können in der Regel entsprechend der Hausanschlußsicherungen zwischen 32 und 63A liegen. Bei der Anwendung eines bekannten Alarmsystems z. B. « VICOM® », das mit einer Frequenz von z. B. 290 kHz arbeitet und das zur Signalübertragung ebenfalls das Niederspannungsleitungsnetz der Hausinstallation benutzt, ist es üblich, als Sperrfilter eine stromkompensierte, quadrofilar gewickelte Spule zu verwenden, bei der auf einem Ringkern vier Spulenwicklungen für die drei Phasen und den Mittelleiter untergebracht sind. Dieser Sperrfilter, der hinter dem Zähler einer Hausinstallation angeordnet werden muß, bedingt ein relativ großes Bauvolumen der Spule, die innerhalb eines Gehäuses gekapselt und im Zählerschrank oder in einer Unterverteilung vor den Sicherungen der einzelnen Stromkreise einer Hausinstallation angeschlossen werden muß. Neben dem großen Bauvolumen ist hierfür die erforderliche Leitungsinstallation auch relativ aufwendig.

Aus GB-A 287847 ist ein Filter mit einer stromkompensierten Drossel bekannt, die aus vier Wicklungen und einem ferromagnetischen Kern besteht, wobei je zwei Wicklungen unmittelbar miteinander verbunden sind und die hierdurch gebildeten Verbindungsstellen ihrerseits über einen Kondensator in Verbindung stehen. Nachteilig hierbei ist, daß die beiden jeweils miteinander verbundenen Wicklungen gegensinnig gewickelt sind. Hierdurch ergibt sich ein relativ komplizierter Wickelvorgang. In gleicher Weise nachteilig wirkt sich aus, daß die Wicklungen nicht insgesamt in Reihe liegen, sondern ein Kondensator-Widerstandsglied zwischengeschaltet ist.

Aufgabe der Erfindung ist es, ein Sperrfilter zu schaffen, das geeignet ist, hohe Ströme zuzulassen, klein dimensioniert ist und eine leichte Installation im Zählerschrank oder der Unterverteilung einer Hausinstallation möglich macht.

Diese Aufgabe wird bei einem Sperrfilter der eingangs genannten Art durch die in Anspruch 1 gekennzeichneten Merkmale gelöst. Weitere Ausgestaltungen und Fortbildungen des Anmeldungsgegenstandes sind in den Unteransprüchen genannt.

Die von dem Kondensator überbrückten Spulenteile bilden mit dem Kondensator einen Parallelresonanzkreis, an dem die HF-Spannung abfallen kann. Die innerhalb des Leitungsnetzes einer Hausinstallation anfallende HF-Sendespannung wird hierdurch einwandfrei gedämpft, so daß eine Übertragung über das interne Installationsnetz hinaus ausgeschlossen ist. Gleichzeitig können fremde Signale, die die hausinterne Signalanlage stören würden, nicht in das interne Netz übertragen werden. Außerdem werden hierdurch nur wenige Spulenwindungen mit einem relativ starken Leitungsquerschnitt benötigt. So ist es hierdurch ermöglicht, daß der 50 Hz-Laststrom die Trägerfrequenzsperrre ungehindert passieren kann, ohne daß eine unzulässige Erwärmung im Sperrfilter oder eine Verschlechterung der Dämpfung durch Sättigungserscheinungen auftreten kann.

Vorteilhafterweise sind dabei die Wicklungen und der Kondensator auf Resonanz-Frequenz abstimmbar.

Eine weitere Verbesserung der Sperrwirkung wird dadurch erreicht, daß zwischen dem netzseitigen Anschluß der Spulenwicklung und dem N-Leiter ein Reihenresonanzkreis, bestehend aus Kondensator und Spule, geschaltet ist. Hierdurch wird die HF-Spannung auf der Zählerseite kurzgeschlossen.

Es ist möglich, die Spule des Reihenresonanzkreises als Abstimmspule auszubilden, wodurch eine optimale Abstimmung zur Erzielung günstiger Dämpfungswerte erfolgt.

Eine weitere Ausbildung der Erfindung besteht darin, daß sein Gehäuse aus zwei gleichförmigen Schalen aufgebaut und mit Ausnehmungen und Aufnahmen für seine Bauteile versehen ist, wobei in beiden Schalen vorgesehen ist : eine zentrale Ausnehmung mit Lagerungen zur Halterung der aus Ferritkern und Spule bestehenden stromkompensierten Drossel in der einen Gehäuseschale und mit seitlichen Aufnahmen zur Halterung einer den Kondensator, die Spule und eine Anschlußklemme des Reihenresonanzkreises tragenden Leiterplatte in der anderen Gehäuseschale, wobei Kanäle zur Aufnahme der in seitlich der zentralen Ausnehmung in Taschen lagernden Anschlußklemmen mündenden Wicklungsenden der Drossel dienen, während oberhalb der zentralen Ausnehmung eine weitere Ausnehmung zur Aufnahme des an Mittenanzapfungen der Spulen angeschlossenen Kondensators vorgesehen ist, wobei sich zwischen der weiteren Ausnehmung und der zentralen Ausnehmung eine Lagerung für eine den Ferritkern in seine Lagerungen drückende Feder befindet.

Hierdurch ist es ermöglicht, trotz der gleichförmigen Ausbildung der beiden Gehäuseschalen einen Teil der unterschiedlichen Bauelemente des Sperrfilters in die eine Gehäuseschale einzulegen, während der andere Teil der Bauelemente in den Ausnehmungen der anderen Gehäuseschale Aufnahme findet. Es ist hierdurch eine kompakte Bauweise möglich, so daß der Sperrfilter innerhalb von Zählerschränken oder Unterverteilungen raumsparend und montagefreundlich installiert werden kann.

Eine weitere Ausgestaltung der Erfindung besteht darin, daß mindestens eine der Taschen für die Anschlußklemmen mit einer Stufe versehen ist, durch die eine kleine Kammer für die Aufnahme der Anschlußklemme des Reihenresonanzkreises und eine größere Kammer für die Aufnahme der Anschlußklemme der Spulenwicklung gebildet ist. Dabei ist durch die Stufe in der Tasche die Anschlußklemme der Spulen von der auf der Leiterplatte festgelegten Anschlußklemme des Reihenresonanzkreises in Abstand gehalten.

Es wird hierdurch eine gute und raumsparende Unterbringung der Anschlußklemmen innerhalb des Gehäuses ermöglicht, wobei zwei in ihrer Baugröße unterschiedliche Anschlußklemmen in Nebeneinanderanordnung in dem erforderlichen Kriech- und Luftabstand in dem Gehäuse untergebracht werden können.

Die Erfindung zeichnet sich weiterhin dadurch aus, daß die Außenkontur der Gehäuseschalen dem Gehäuseprofil von Leitungsschutzschaltern und dergl. Geräten zum Aufbau auf einer Normprofilschiene in Verteilungsanlagen entspricht, wobei die zentrale Ausnehmung und die seitlich von dieser vorgesehenen Taschen für die Anschlußklemmen im unteren breiteren Sockelbereich nebeneinander angeordnet sind, während sich die weitere Ausnehmung für den an Mittenanzapfungen der Spulen angeschlossenen Kondensator im über diesem Sockelbereich liegenden schmaleren Gehäuseteil befindet.

Schließlich sind in den Wandabschnitten der Gehäuseschalen zwischen der zentralen Ausnehmung und einem auf der Normprofilschiene aufliegenden Boden Lagerungen für die Halterung von Klemmfedern zur Befestigung an der Normprofilschiene vorgesehen.

Hierdurch ist das Gehäuse so ausgeführt, daß das Sperrfilter innerhalb von Zählerschränken oder Unterverteilungen auf Normprofilschienen z. B. nach DIN 46277 in Verbindung mit Leitungsschutzschaltern oder anderer Geräte untergebracht werden kann.

Ein Ausführungsbeispiel der Erfindung wird nachstehend anhand der Zeichnung näher erläutert. Es zeigt

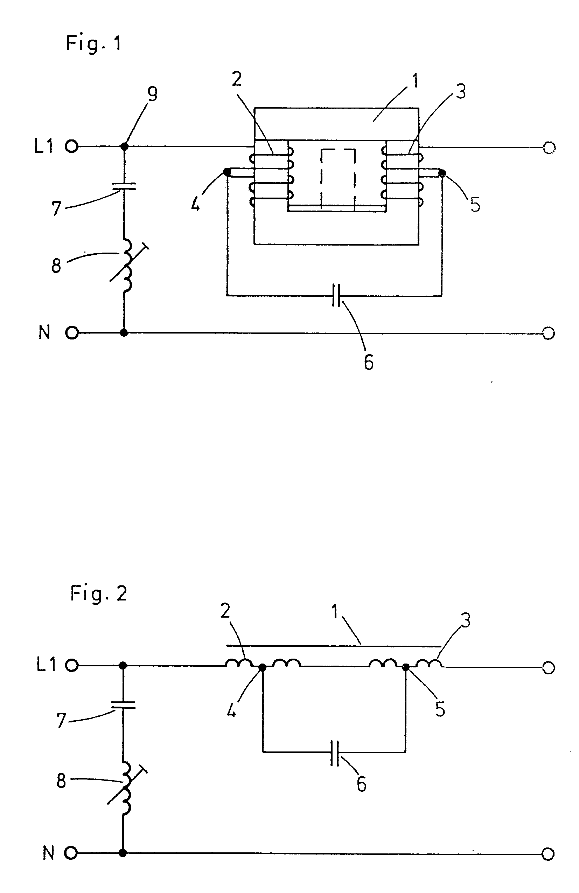

Figur 1 eine schematische Darstellung über den Aufbau des Sperrfilters,

Figur 2 ein Schaltbild des Sperrfilters,

Figur 3 ein Diagramm über die HF-Spannungspegel,

Figur 4 eine Ansicht einer Gehäuseschale mit den in dieser eingesetzten Bauteilen des Sperrfilters,

Figur 5 eine Seitenansicht des Gehäuses,

Figur 6 einen Querschnitt durch das Gehäuse gemäß Schnittlinie III-III der Fig. 4 und

Figur 7 eine Ansicht der anderen Gehäuseschale mit den in dieser angeordneten Bauteilen.

Auf einem Ferritkern 1 sind zwei Spulen 2, 3 so angeordnet, daß eine stromkompensierte Drossel entsteht. Der Betriebsstrom durchfließt sie dabei derart, daß sich die erzeugten Magnetfelder innerhalb der Drossel weitgehend aufheben, so daß die Drossel für den Betriebsstrom nur einen geringen Widerstand bildet. Die Spulen 2 und 3 besitzen jeweils eine Mittenanzapfung 4 und 5, an denen ein Kondensator 6 angeschlossen ist. Dieser bildet mit den überbrückten Teilen der Spulen 2 und 3 einen Parallelresonanzkreis, an dem die HF-Spannung abfallen kann. Die Wicklungen 2 und 3 und der Kondensator 6 sind dabei so abgestimmt, daß je nach der zu übertragenden Signalfrequenz eine maximale Dämpfung erzielt wird. Bei Anwendung des Sperrfilters zur Dämpfung einer Sendefrequenz von z. B. 125 kHz genügen so lediglich vier Windungen auf jeder Spule. Der netzseitige Anschluß 9 der Spulenwicklung ist über einen aus einem weiteren Kondensator 7 und einer weiteren Spule 8 bestehenden Reihenresonanzkreis mit dem Mittelleiter N verbunden. Für eine optimale Abstimmung der zu erzielenden Dämpfung der Sendefrequenz ist die Spule 8 als Abstimmspule ausgebildet.

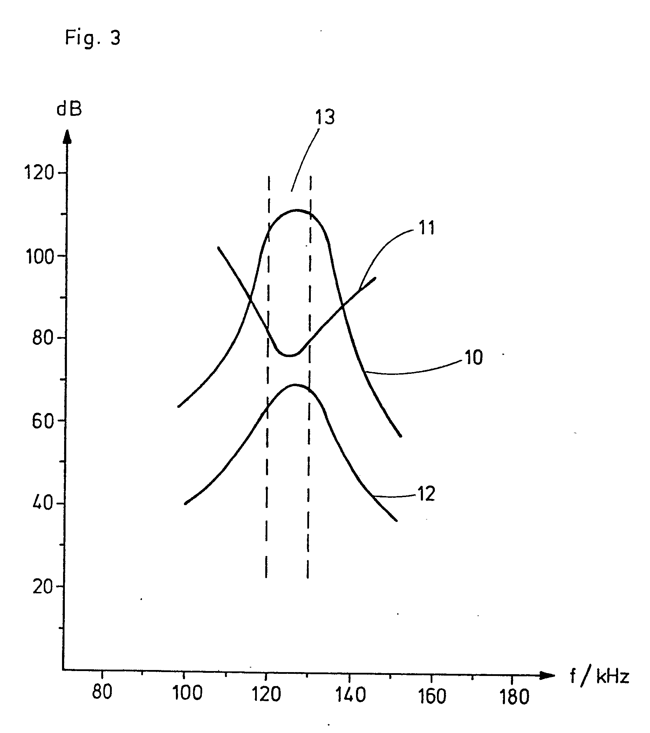

In Figur 3 sind die Spannungspegel einer im Bereich eines Hausinstallationsnetzes verwendeten Signaleinrichtung und ein durch den Einbau eines Sperrfilters erzielter Spannungspegel in einem Koordinaten-System dargestellt. Bei einer Wechselsprechanlage, die aufgrund der postalischen Bestimmungen eine maximale Nutzleistung von 5 mW haben darf, ist es üblich, diese Geräte innerhalb einer Bandbreite von z. B. 125 ± 4kHz zu betreiben. Diese Bandbreite ist in Figur 3 mit 13 angegeben. Die Kurve 10 bezeichnet den Sendepegel und die Kurve 11 die Ansprechgrenze einer solchen Anlage. Mit 12 ist der Spannungspegel auf der Zählerseite unter Berücksichtigung der Dämpfungen angegeben. Wie zu ersehen ist, ergeben sich bei einer 50 Netznachbildung, die annähernd ein Hausinstallationsnetz darstellt, ein maximaler Sendepegel von 112 dB. Der Empfangspegel der Signaleinrichtung liegt bei ca. 77 dB. Der mit dem Sperrfilter gemäß der Erfindung erzielte Spannungspegel 12 erreicht unter Berücksichtigung der Dämpfungen innerhalb des Hausinstallationsnetzes nicht mehr den Empfangspegel 11. Es wird somit durch das erfindungsgemäße Sperrfilter einwandfrei vermieden, daß die HF-Spannungen eines internen Leitungsnetzes über den Bereich dieses Netzes hinaus ausgebreitet werden. Eine zusätzliche Dämpfung durch den vorgeschalteten Zähler ist hierbei noch nicht berücksichtigt.

Der beschriebene Sperrfilter kann so klein dimensioniert werden, daß er innerhalb eines Gehäuses untergebracht werden kann, das dem eines Leitungsschutzschalters oder dergl. angepaßt ist. Somit kann der Sperrfilter innerhalb eines Zählerschrankes oder einer Unterteilung leicht auf einer Tragschiene neben den Leitungsschutzschaltern installiert werden. Je nachdem ob eine oder mehrere Phasenleitungen eines Hausinstallationsnetzes für die Übertragung von Signalfrequenzen benutzt werden müssen, sind ein, zwei oder drei Sperrfilter in einer Installationsanlage erforderlich. Bei Verwendung mehrer Phasenleitungen sind in bekannter Weise zwischen diesen zusätzliche Phasenkoppler einzusetzen. Bei dem Sperrfilter nach der Erfindung ist es jedoch nicht erforderlich, den Mittelleiter durch die Spule zu legen, so daß gegenüber bekannten Einrichtungen die Installation wesentlich vereinfacht ist.

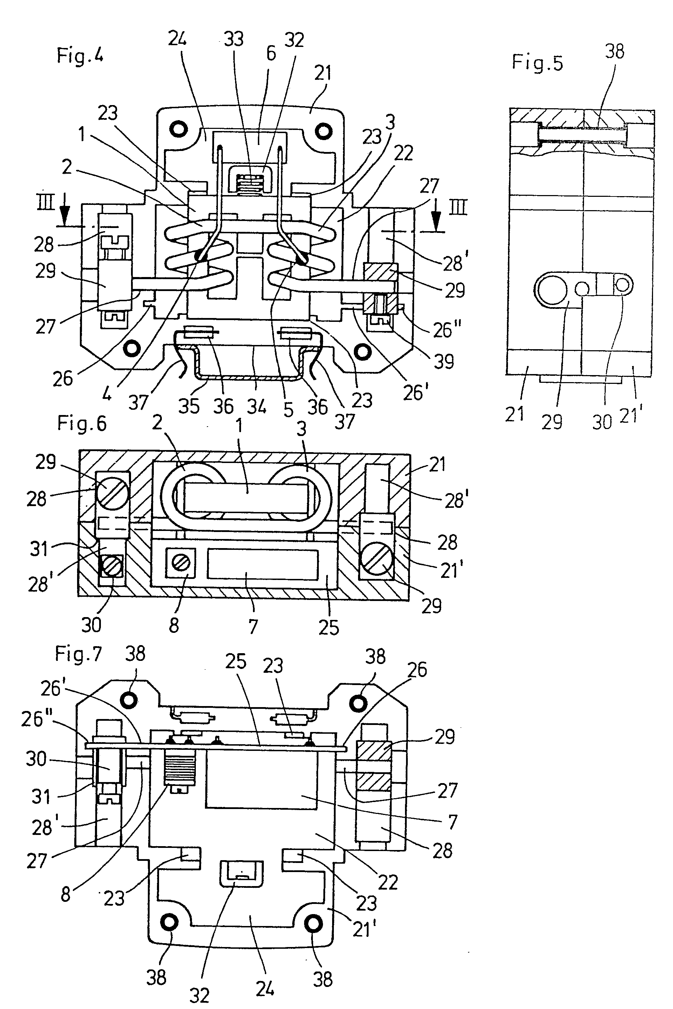

Bei dem in den Fig. 4 bis 7 dargestellten Beispiel einer Gehäusekapselung sind die das Gehäuse bildenden Gehäuseschalen 21 und 21' völlig gleichförmig ausgebildet. Ihr Innenraum besitzt eine zentrale Ausnehmung 22 mit Lagerungen 23 und seitlich angeformten Aufnahmen 26 und Kanälen 27. In die zentrale Ausnehmung 22 der einen Gehäuseschale 21 findet die aus Ferritkern 1 und Spule 2, 3 bestehende stromkompensierte Drossel ihre Aufnahme. Die zentrale Ausnehmung 22 der anderen Gehäuseschale 21' nimmt dagegen die Bauteile des Reihenresonanzkreises, und zwar den Kondensator 7 und die Spule 8 auf. Diese sind auf einer Leiterplatte 25 befestigt und stehen elektrisch einerseits mit einer ebenfalls an der Leiterplatte 25 befestigten Anschlußklemme 30 in Verbindung, während das andere Ende des Reihenresonanzkreises mit einem Ende der Spulenwicklung 2, 3 verbunden ist. Die Leiterplatte 25 findet dabei Aufnahme in seitlich der Ausnehmung 22 der Gehäuseschale 21, 21' angeformten Aufnahmen 26, 26' und 26".

Seitlich der zentralen Ausnehmung 22 sind noch Taschen 28 und 28' in den Gehäuseschalen 21, 21' angebracht für die Aufnahme von Anschlußklemmen 29 und 30.

Die Drossel wird an den freien Enden ihrer Spulen 2, 3 mit den Anschlußklemmen 30, z. B. mittels der Schrauben 39 verbunden. Die aus Drossel und an deren Spulen, 2, 3 an Mittenanzapfungen 4, 5 angeschlossenem Kondensator 6 bestehende Baugruppe wird in die entsprechenden Ausnehmungen und Aufnahmen der Gehäuseschale 21 eingelegt. Dabei wird der Ferritkern 1 in Lagerungen 23 innerhalb der zentralen Ausnehmung 22 eingelegt und mittels einer Druckfeder 33, die an einem ortsfesten Lagersteg 32 der Gehäuseschale abgestützt ist, in diesen Lagerungen 23 festgehalten. Der Kondensator 6 findet Aufnahme in einer weiteren Ausnehmung 24 der Gehäuseschale, die oberhalb der zentralen Ausnehmung 22 angeordnet ist und wobei zwischen diesen Ausnehmungen 22 und 24 sich die Lagerung 32 für die Druckfeder 33 befindet. Die Wicklungsenden der Spule 2, 3 finden Aufnahme in Kanälen 27, die die zentrale Ausnehmung 22 mit den Taschen 28 und 28' verbinden. In diese Taschen 28 und 28' werden die Anschlußklemmen 29 eingesetzt, die zum Anschluß der Netzleitungen dienen. Nach Einlegen des auf der Leiterplatte 25 angeordneten Reihenresonanzkreises in die andere Gehäuseschale 21' werden die Gehäuseschalen zusammengeklappt und mittels Nieten oder Schrauben 38 miteinander verbunden. Die zum Anschluß des Reihenresonanzkreises an den Mittelleiter vorgesehene Anschlußklemme 30 findet dabei innerhalb einer kleineren Kammer der Tasche 28', die durch eine Abstufung 31 gebildet ist, Aufnahme. Auf der Stufe 31 gelangt die Anschlußklemme 29 der Drossel zum Anschlag, wodurch sie in einem ausreichenden Kriech- und Luftabstand von der auf der Leiterplatte 25 festgelegten Anschlußklemme 30 gehalten ist. Die Leiterplatte 25 hat eine bis zur Stufe 31 reichende Breite, wodurch sie von der auf Stufe 31 und somit auf der Leiterplatte 25 abgestützten Anschlußklemme 29 in ihrer Lage zuverlässig gehalten ist. Diese Halterung wird weiterhin dadurch verstärkt, daß die Länge der Leiterplatte 25 so ausgeführt ist, daß sie in die Aufnahmen 26 und 26" relativ schließend eingeführt werden kann. Unterhalb der zentralen Ausnehmung 22 und zwischen dieser und einem Befestigungsboden 34 des Gehäuses sind noch Lagerungen 36 für die Aufnahme von Klemmfedern 37 für die Befestigung des Gehäuses auf einer Normprofilschiene 35 vorgesehen.

**Ansprüche**

1. Sperrfilter mit mindestens einem Resonanzkreis, der als Parallelresonanzkreis ausgebildet ist und eine aus vier Wicklungen und einem ferromagnetischen Kern (1) bestehende stromkompensierte Drossel besitzt, bei der je zwei Wicklungen unmittelbar miteinander verbunden sind und die beiden hierdurch gebildeten Verbindungsstellen (4, 5) ihrerseits über einen Kondensator (6) in Verbindung stehen, dadurch gekennzeichnet, daß jeweils die beiden Wicklungen, an deren Verbindungsstelle (4, 5) der Kondensator (6) liegt, zu je einer in gleicher Richtung durchgehend gewickelten Spule (2, 3) zusammengefaßt sind, und die beiden Spulen (2, 3) ihrerseits unmittelbar in Reihe liegen, und daß die stromkompensierte Drossel mit den übrigen Bauteilen des Sperrfilters eine von einem Gehäuse umschlossene Baueinheit bildet und mit den beiden freien Enden ihrer Spulen (2, 3) unmittelbar in den Hauptstromkreis eines Niederspannungsnetzes geschaltet ist und daß bei Bedarf der Parallelresonanzkreis durch einen Reihenresonanzkreis (7, 8) ergänzt ist, der zum Niederspannungsnetz parallel geschaltet ist.

2. Sperrfilter nach Anspruch 1, dadurch gekennzeichnet, daß der aus dem Kondensator (6) und den beiden von ihm überbrückten Wicklungen der Spulen (2, 3) gebildete Parallelresonanzkreis abstimmbar ist.

3. Sperrfilter nach Anspruch 1 oder 2, dadurch gekennzeichnet, daß zwischen dem netzseitigen Anschluß (9) der Spulenwicklung und dem N-Leiter des Niederspannungsnetzes der Reihenresonanzkreis, bestehend aus einem Kondensator (7) und einer Spule (8), geschaltet ist.

4. Sperrfilter nach Anspruch 3, dadurch gekennzeichnet, daß die Spule (8) des Reihenresonanzkreises als Abstimmspule ausgebildet ist.

5. Sperrfilter nach einem der Ansprüche 1 bis 4, dadurch gekennzeichnet, daß sein Gehäuse aus zwei gleichförmigen Schalen (21, 21') aufgebaut und mit Ausnehmungen und Aufnahmen für seine Bauteile versehen ist, wobei in beiden Schalen (21, 21') vorgesehen ist : eine zentrale Ausnehmung (22) mit Lagerungen (23) zur Halterung der aus Ferritkern (1) und Spulen (2, 3) bestehenden stromkompensierten Drossel in der einen Gehäuseschale (21) und mit seitlichen Aufnahmen (26, 26', 26'') zur Halterung einer den Kondensator (7), die Spule (8) und eine Anschlußklemme (30) des Reihenresonanzkreises tragenden Leiterplatte (25) in der anderen Gehäuseschale (21'), wobei Kanäle (27) zur Aufnahme der in seitlich der zentralen Ausnehmung (22) in Taschen (28, 28') lagernden Anschlußklemmen (29) mündenden Spulenenden der Drossel dienen, während oberhalb der zentralen Ausnehmung (22) eine weitere Ausnehmung (24) zur Aufnahme des an Mittenanzapfungen (4, 5) der Spulen (2, 3) angeschlossenen Kondensators (6) vorgesehen ist, wobei sich zwischen der weiteren Ausnehmung (24) und der zentralen Ausnehmung (22) eine Lagerung (32) für eine den Ferritkern (1) in seine Lagerungen (23) drückende Feder (33) befindet.

6. Sperrfilter nach Anspruch 5, dadurch gekennzeichnet, daß mindestens eine der Taschen (28, 28') für die Anschlußklemmen (29, 30) mit einer Stufe (31) versehen ist, durch die eine kleine Kammer für die Aufnahme der Anschlußklemme (30) des Reihenresonanzkreises und eine größere Kammer für die Aufnahme der Anschlußklemme (29) der Spule (2) gebildet ist.

7. Sperrfilter nach Anspruch 6, dadurch gekennzeichnet, daß durch die Stufe (31) in der Tasche (28') die Anschlußklemme (29) der Spulen (2, 3) von der auf der Leiterplatte (25) festgelegten Anschlußklemme (30) des Reihenresonanzkreises in Abstand gehalten ist.

8. Sperrfilter nach einem der Ansprüche 5 bis 7, dadurch gekennzeichnet, daß die Aussenkontur der Gehäuseschalen (21, 21') dem Gehäuseprofil von Leitungsschutzschaltern und dergl. Geräten zum Aufbau auf einer Normprofilschiene (35) in Verteilungsanlagen, wobei die zentrale Ausnehmung (22) und die seitlich von dieser vorgesehenen Taschen (28, 28') für die Anschlußklemmen (29, 30) im unteren breiteren Sockelbereich nebeneinander angeordnet sind, während sich die weitere Ausnehmung (24) für den an Mittenanzapfungen der Spulen (2, 3) angeschlossenen Kondensator (6) im über diesem Sockelbereich liegenden schmaleren Gehäuseteil befindet.

9. Sperrfilter nach Anspruch 8, dadurch gekennzeichnet, daß in den Wandabschnitten der Gehäuseschalen (21, 21') zwischen der zentralen Ausnehmung (22) und einem auf der Normprofilschiene (35) aufliegenden Boden (34) Lagerungen (36) für die Halterung von Klemmfedern (37) zur Befestigung an der Normprofilschiene (35) vorgesehen sind.

## Claims

1. A stop filter with at least one resonant circuit, which is in the form of a parallel resonant circuit and has a current-compensated choke, which consists of four windings and one ferromagnetic core (1) and in which two windings in each case are connected directly to each other and the two connection points (4, 5) formed in this way are, for their part, connected by way of a capacitor (6), characterized in that, in each case, the two windings, at whose connection point (4, 5) the capacitor (6) lies, are each combined to form a coil (2, 3) which is continously wound in the same direction, and the two coils (2, 3), for their part, are directly in series, and in that the current-compensated choke with the remaining structural parts of the stop filter forms a structural unit enclosed by a casing and is connected into the main circuit of a low-voltage mains by means of the two free ends of its coils (2, 3), and in that, where necessary, the parallel resonant circuit is supplemented by a series resonant circuit (7, 8) which is connected in parallel to the low-voltage mains.

2. A stop filter according to claim 1, characterized in that the parallel resonant circuit formed by the capacitor (6) and the two windings of the coils (2, 3) which are bridged by the capacitor can be tuned.

3. A stop filter according to claim 1 or 2, characterized in that the series resonant circuit, consisting of a capacitor (7) and a coil (8), is connected between the connection (9) of the coil winding at the mains and the n-conductor of the low-voltage mains.

4. A stop filter according to claim 3, characterized in that the coil (8) of the series resonant circuit is in the form of a tuning coil.

5. A stop filter according to one of claims 1 to 4, characterized in that its casing is composed of two uniform shells (21, 21') and is provided with recesses and holding parts for its structural parts, there being provided in both shells (21, 21') : a central recess (22) with mountings (23) for holding the current-compensated choke consisting of a ferrite core (1) and coils (2, 3) in one (21) of the casing shells and with lateral holding parts (26, 26', 26'') for holding a printed circuit board (25) which carries the capacitor (7), the coil (8) and a terminal (3) of the series resonant circuit in the other casing shell (21'), channels (27) being used to accommodate the coil ends of the choke which open into terminals (29) which are mounted laterally of the central recess (22) in pockets (28, 28'), whereas, a further recess (24) for accommodating the capacitor (6) which is connected to central taps (4, 5) of the coils (2, 3) is provided above the central recess (22), there being a mounting (32) for a spring (33), which presses the ferrite core (1) into its mountings (23), between the further recess (24) and the central recess (22).

6. A stop filter according to claim 5, characterized in that at least one of the pockets (28, 28') for the terminals (29, 30) is provided with a step (31), by means of which a small chamber for accommodating the terminal (30) of the series resonant circuit and a larger chamber for accommodating the terminal (29) of the coil (2) are formed.

7. A stop filter according to claim 6, characterized in that by means of the step (31) in the pocket (28'), the terminal (29) of the coils (2, 3) is kept at a distance from the terminal (30), of the series resonant circuit, which is fixed on the printed circuit board (25).

8. A stop filter according to one of claims 5 to 7, characterized in that the outer contour of the casing shells (21, 21') [corresponds] to the casing profile of circuit breakers and similar apparatus for mounting on a standard profiled rail (35) in distribution systems, the central recess (22) and the pockets (28, 28') for the terminals (29, 30), which are provided laterally of the central recess, being disposed side by side in the lower wider base area, whilst the further recess (24) for the capacitor (6), which is connected to the central taps of the coils (2, 3), lies in the narrower casing part above this base area.

9. A stop filter according to claim 8, characterized in that mountings (36) for holding clamping springs (37) for fixing on the standard profiled rail (35) are provided in the wall sections of the casing shells (21, 21') between the central recess (22) and a base (34) which rests on the standard profiled rail (35).

**Revendications**

1. Filtre de blocage comprenant au moins un circuit de résonance qui est conformé comme un circuit de résonance parallèle et comporte une bobine d'arrêt compensée en courant constituée par quatre enroulements et par un noyau ferromagnétique (1), et dans laquelle deux enroulements respectifs sont réunis directement l'un à l'autre et les deux emplacements de liaison (4, 5) formés ainsi sont en liaison de leur côté par l'intermédiaire d'un condensateur (6), caractérisé en ce que les deux enroulements respectifs, à l'emplacement de liaison (4, 5) desquels se trouve le condensateur (6), sont rassemblés pour former une bobine respective (2, 3) enroulée de façon continue dans le même sens, et les deux bobines (2, 3) se trouvent de leur côté directement en série, et en ce que la bobine d'arrêt compensée en courant avec les autres composants du filtre de blocage constitue une unité structurelle entourée par un boîtier et est commutée avec les deux extrémités libres de ces bobines (2, 3) directement dans le circuit de courant principal d'un réseau basse tension, et en ce que si besoin est le circuit de résonance parallèle est complété par un circuit de résonance série (7, 8) qui est commuté en parallèle sur le réseau basse tension.

2. Filtre de blocage selon la revendication 1, caractérisé en ce que le circuit de résonance parallèle formé par le condensateur (6) et par les deux enroulements des bobines (2, 3) chevauchés par le condensateur est accordable.

3. Filtre de blocage selon la revendicaiton 1 ou la revendication 2, caractérisé en ce que le circuit de résonance série constitué par un condensateur (7) et par une bobine (8) est monté entre le raccordement du côté réseau (9) de l'enroulement de bobine et le conducteur (N) du réseau basse tension.

4. Filtre de blocage selon la revendication 3, caractérisé en ce que la bobine (8) du circuit de résonance série est conformée comme une bobine d'accord.

5. Filtre de blocage selon l'une des revendications 1 à 4, caractérisé en ce que son boîtier est constitué de deux coquilles de même forme (21, 21') et est muni d'évidements et de logements pour ses composants, tandis que dans les deux coquilles (21, 21') on prévoit : un évidement central (22) avec des éléments de montage (23) pour maintenir la bobine d'arrêt compensée en courant constituée par un noyau en ferrite (1) et par des bobines (2, 3) dans l'une des coquilles de boîtier (21) et des logements latéraux (26, 26', 26'') pour maintenir une plaque de conducteur (25) portant le condensateur (7), la bobine (8) et une borne de raccordement (30) du circuit de résonance série dans l'autre coquille de boîtier (21'), des canaux (27) servant à recevoir des extrémités de bobine de la bobine d'arrêt débouchant dans des bornes de raccordement (29) situées dans des poches (28, 28') latéralement par rapport à l'évidement central (22), tandis qu'au-dessus de l'évidement central (22) on prévoit un autre évidement (24) pour recevoir le condensateur (6) raccordé à des prises centrales (4, 5) des bobines (2, 3), un emplacement (32) destiné à un ressort (33) poussant le noyau de ferrite (1) dans ses éléments de montage (23) se trouvant entre l'autre évidement (24) et l'évidement central (22).

6. Filtre de blocage selon la revendication 5, caractérisé en ce qu'au moins l'une des poches (28, 28') destinées aux bornes de raccordement (29, 30) est munie d'un gradin (31) par lequel sont formées une petite chambre pour recevoir la borne de raccordement (30) du circuit de résonance série et une chambre plus grande pour recevoir la borne de raccordement (29) de la bobine (2).

7. Filtre de blocage selon la revendication 6, caractérisé en ce que, au moyen du gradin (31) se trouvant dans la poche (28'), la borne de raccordement (29) des bobines (2, 3) est maintenue à distance de la borne de raccordement (30) du circuit de résonance série fixée sur la plaque de conducteur (25).

8. Filtre de blocage selon l'une des revendications 5 à 7, caractérisé en ce que le contour externe des coquilles de boîtier (21, 21') suit le profil de boîtier de commutateurs de protection de conducteurs et éléments analogues pour obtenir un montage sur un rail profilé normalisé (35) dans des installations de distribution, l'évidement central (22) et les poches (28, 28') prévues latéralement par rapport à celui-ci et destinées aux bornes de raccordement (29, 30) sont disposés dans la zone inférieure plus large d'embase les uns à côté des autres, tandis que l'autre évidement (24) destiné au condensateur (6) raccordé aux prises centrales des bobines (2, 3) se trouve dans une partie de boîtier plus étroite se trouvant au-dessus de cette zone d'embase.

9. Filtre de blocage selon la revendication 8, caractérisé en ce que dans les sections de paroi des coquilles de boîtier (21, 21') sont prévus, entre l'évidement central (22) et un fond (34) reposant sur le rail profilé normalisé (35), des emplacements (36) pour maintenir des ressorts de serrage (37) destinés à la fixation sur le rail profilé normalisé (35).

Fig. 1

Fig. 2

Fig. 3

Fig.4

Fig.5

Fig.6

Fig.7